# EUROPÄISCHE PATENTSCHRIFT

(11) **EP 3 491 467 B1**
(45) Veröffentlichungstag und Bekanntmachung des Hinweises auf die Patenterteilung: **15.11.2023**
(21) Anmeldenummer: 17735498.2
(22) Anmeldetag: 04.07.2017
(51) Int. Cl.: G03F 7/20, G02B 26/08

(54) **VERFAHREN ZUR EINSTELLUNG EINES BELEUCHTUNGSSETTINGS**
METHOD FOR ADJUSTING A LIGHTING SETTING
PROCÉDÉ DE MISE AU POINT D'UN RÉGLAGE D'ÉCLAIRAGE

(30) Priorität: 27.07.2016 DE 102016213785
(43) Veröffentlichungstag der Anmeldung: 05.06.2019
(73) Patentinhaber: Carl Zeiss SMT GmbH, 73447 Oberkochen (DE)
(72) Erfinder: WINKLER, Alexander, 89520 Heidenheim (DE); LENZ, Daniel, 73434 Aalen (DE)
(74) Vertreter: Rau, Schneck & Hübner Patentanwälte Rechtsanwälte PartGmbB
(86) Internationale Anmeldenummer: PCT/EP2017/066583
(87) Internationale Veröffentlichungsnummer: WO 2018/019522

(56) Entgegenhaltungen:
- DE-A1-102012 212 664
- DE-A1-102014 220 203
- US-A1- 2012 262 689

## Beschreibung

Die Erfindung betrifft ein Verfahren zur Einstellung eines Beleuchtungssettings zur Beleuchtung eines Objektfeldes einer Projektionsbelichtungsanlage. Die Erfindung betrifft außerdem einen Facettenspiegel für eine Beleuchtungsoptik, eine Beleuchtungsoptik und ein Beleuchtungssystem sowie eine Projektionsbelichtungsanlage für die Mikrolithographie. Schließlich betrifft die Erfindung ein Verfahren Herstellung eines mikro- oder nanostrukturierten Bauelements.

Ein Verfahren zur Beleuchtung eines Objektfeldes einer Projektionsbelichtungsanlage ist beispielsweise aus der DE 10 2013 203 689 A1 bekannt.

Aus der US 2012/0262689 A1 ist eine Lithographieanlage bekannt. Aus der DE 10 2012 212 664 A1 ist ein Verfahren zum Einstellen eines Beleuchtungssettings bekannt. Aus der DE 10 2014 220 203 A1 ist eine mikrolithographische Projektionsbelichtungsanlage bekannt.

Es besteht fortwährend Bedarf, derartige Verfahren zu verbessern. Es besteht insbesondere Bedarf, derartige Verfahren robuster zu machen, das heißt die Sensitivität gegenüber Störungen und/oder Schwankungen der Beleuchtungsstrahlung zu verringern.

Diese Aufgabe wird durch ein Verfahren gemäß Anspruch 1 gelöst. Der Kern der Erfindung besteht darin, die Beleuchtungspupille, insbesondere das Beleuchtungssetting, derart anzupassen, dass Beleuchtungsstrahlung vornehmlich, insbesondere ausschließlich, in Bereiche der Beleuchtungspupille gelenkt wird, welche eine geringe Sensitivität gegenüber Verschiebungen und/oder Schwankungen der Intensität der Beleuchtungsstrahlung aufweisen.

Erfindungsgemäß wurde erkannt, dass bestimmte Parameter zur Charakterisierung der Qualität der Beleuchtung des Objektfeldes, sogenannte Performancegrößen, eine unterschiedliche Abhängigkeit von einer Intensitätsänderung an einem bestimmten Pupillenort (ΔI (x,y)) aufweisen.

Es wurde weiter festgestellt, dass es ausgedehnte, zusammenhängende Bereiche gibt, in welchen die Abhängigkeit einer Performancegröße von der Intensitätsänderung der Beleuchtungsstrahlung konstant ist. Diese Bereiche, welche im Folgenden als Bereiche konstanter Sensitivität bezeichnet werden, können durch relativ scharf berandete Kanten voneinander getrennt sein. Es wurde erkannt, dass es für die Stabilität der Beleuchtung eines Objektfeldes vorteilhaft ist, wenn die Kantenbereiche vermieden werden, das heißt die Pupillenspots nicht im Bereich einer Begrenzungskante zwischen zwei Bereichen konstanter Sensitivität in Bezug Intensitätsänderungen der Beleuchtungsstrahlung angeordnet sind. Anders ausgedrückt, ist es vorteilhaft, wenn zumindest die Mehrheit, insbesondere mindestens 60 %, insbesondere mindestens 70 %, insbesondere mindestens 80 %, insbesondere mindestens 90 %, insbesondere sämtliche Pupillenspots in Bereiche konstanter Sensitivität angeordnet sind, insbesondere einen Mindestabstand von den Randbereichen zwischen zwei Beriechen unterschiedlicher Sensitivität aufweisen.

Hierdurch ist es möglich, die Sensitivität der Beleuchtungspupille gegenüber Schwankungen und/oder Störungen der Beleuchtungsstrahlung zu verringern. Die Beleuchtung wird damit robuster.

Es ist damit möglich, die Performance der Pupille in realen, mit Toleranzen behafteten Systemen an die Designperformance eines idealen Systems anzupassen. Es ist insbesondere möglich, die gewählte Performancegröße im realen System an ihren Idealwert anzunähern. Hierdurch wird insbesondere die Präzision der Beleuchtung des Objektfeldes und damit der Projektionsbelichtungsanlage verbessert.

Es ist insbesondere vorgesehen, die Beleuchtungssettings zur Beleuchtung des Objektfeldes an eine Norm einer Richtungsableitung einer Funktion, welche die Abhängigkeit des mindestens einen Parameters zur Charakterisierung der Qualität der Beleuchtung des Objektfeldes von einer Änderung der Intensitätsverteilung der Beleuchtungsstrahlung in der Beleuchtungspupille beschreibt, anzupassen. Bei der Norm kann es sich beispielsweise um eine Sobelnorm handeln.

Bei den Beleuchtungssettings, welche an die Norm angepasst werden, kann es sich um tatsächlich eingestellte Beleuchtungssettings, grundsätzlich einstellbare Beleuchtungssettings, insbesondere um sämtliche einstellbaren Beleuchtungssettings oder um eine Auswahl bestimmter Beleuchtungssettings, insbesondere um von einem Anwender vorgegebene Beleuchtungssettings handeln.

Als Beleuchtungssetting wird jeweils die Gesamtheit der Beleuchtungskanäle, welche zur Beleuchtung des Objektfeldes genutzt werden, bezeichnet. Die Beleuchtungskanäle werden hierbei jeweils insbesondere durch eine Zuordnung einer Facette eines ersten facettierten Elements, insbesondere eines ersten Facettenspiegels, insbesondere eines Feldfacettenspiegels, zu einer Facette eines zweiten facettierten Elements, insbesondere eines zweiten Facettenspiegels, insbesondere eines Pupillenfacettenspiegels, gebildet. Die Facetten des ersten Facettenelements und/oder die Facetten des zweiten Facettenelements können jeweils monolithisch ausgebildet sein. Sie können auch als virtuelle Facetten ausgebildet sein, insbesondere durch eine Gruppierung von Teilfacetten, insbesondere in Form von Mikrospiegeln, gebildet sein. Sie können grundsätzlich jeweils einfach zusammenhängend ausgebildet sein oder auch eine Mehrzahl von separaten, unzusammenhängenden Teilbereichen umfassen. Für Details der Ausbildung der facettierten Elemente sei auf den bekannten Stand der Technik, insbesondere die DE 10 2011 006 100 A1 und die DE 10 2013 203 689 A1.

Als Beleuchtungspupille wird insbesondere eine konkrete Auswahl von Pupillenspots aus sämtlichen möglichen Pupillenspots, des zur Beleuchtung des Objektfeldes genutzten Bereichen der Beleuchtungspupille, welche von einem Beleuchtungskanal ausgeleuchtet werden, bezeichnet.

Erfindungsgemäß wurde weiter erkannt, dass die Qualität der Beleuchtung des Objektfeldes beziehungsweise insbesondere eines im Objektfeld angeordneten Retikels mit vorgegebenen abzubildenden Strukturen, einerseits von diesen Strukturen, andererseits von der jeweils zur Beleuchtung dieses Retikels verwendeten Beleuchtungspupille abhängt. Die Qualität der Beleuchtung kann durch sogenannte Performancegrößen, das heißt Paramater zur Charakterisierung der Qualität der Beleuchtung des Objektfeldes, charakterisiert werden. Als Parameter zur Charakterisierung der Qualität der Beleuchtung des Objektfeldes kann beispielsweise die Position einer Luftbildkante dienen, insbesondere die Position einer Luftbildkante als Funktion des Ortes in der Waferebene, welche auch als Abbildungsebene bezeichnet wird, wobei eine Defokusierung berücksichtigt werden kann. Aus der Kantenposition lassen sich sogenannte kritische Dimensionen (critical dimensions, CDs) berechnen. Hierunter wird insbesondere der Abstand zweier Luftbildkanten für eine Defokusierung z = 0 verstanden. Ein weiterer Parameter zur Charakterisierung der Qualität der Beleuchtung des Objektfeldes ist beispielsweise ein Overlay-Fehler, welcher den Versatz, den eine Struktur bei einer Variation von z erfährt, angibt. Dies wird auch als Imaging-Telezentrie bezeichnet.

Besonders gebräuchlich zur Charakterisierung der Qualität der Beleuchtung des Objektfeldes ist die CD. Diese Größe bietet sich insbesondere bei Masken bei linienförmigen Strukturen an. Sie bietet sich insbesondere zur Optimierung der Beleuchtung von komplexeren Logik-Strukturen an. Derartige Strukturen weisen hauptsächlich oder ausschließlich Liniensegmente auf. Grundsätzlich sind auch Ecken und Rundungen möglich.

Weitere Parameter zur Charakterisierung der Qualität der Beleuchtung des Objektfeldes sind: Die Uniformität der CD (CDU), HV-Performance Line Edge Roughness, Line Width Roughness, Tip-to-Tip Abstände kritischer Features, die Kantensteilheit (normalized image log slope, NILS), Kontrast. HV-Performance bezeichnet die Ähnlichkeit/Differenz des CD-Fehlers für horizontale (H) und vertikale (V) vergleichbare Strukturen. D.h., hat der CD-Fehler für bspw. horizontale und vertikale Linien gleicher Größe, das gleiche Vorzeichen und die gleiche Amplitude, so ist die HV-Performance 0 (der bestmögliche Wert).

Gemäß einem Aspekt der Erfindung wird zumindest eine dieser Performancegrößen bei der Anpassung des Beleuchtungssettings berücksichtigt. Gemäß einem weiteren Aspekt der Erfindung ist vorgesehen, zwei oder mehr dieser Performancegrößen bei der Anpassung des Beleuchtungssettings zu berücksichtigen.

Durch die Auswahl der Performancegrößen, welche bei der Anpassung des Beleuchtungssettings berücksichtigt werden, kann bestimmt werden, welche Performancegrößen robust, das heißt insensitiv gegenüber Störungen und/oder Schwankungen der Beleuchtungsstrahlung, welche in einem realen Beleuchtungssystem stets auftreten können, sind. Bei den Störungen kann es sich insbesondere um die geometrische und/oder energetische Störungen, beispielsweise aufgrund von Fertigungstoleranzen und/oder Schwingungen im Beleuchtungssystem, handeln. Durch das erfindungsgemäße Verfahren zur Einstellung des Beleuchtungssettings, insbesondere zur Anpassung des Beleuchtungssettings, kann erreicht werden, dass die ausgewählten Performancegrößen im realen System, das heißt beim tatsächlichen Betrieb der Projektionsbelichtungsanlage, zumindest annähernd so gut sind wie in einem idealen System. Hierdurch wird die real erreichbare 'Performance des Beleuchtungssystems erheblich verbessert. Im besten Fall wird die tatsächliche Performance des Beleuchtungssystems bis zur theoretischen Performance eines im Hinblick auf einen bestimmten Störungstyp toleranzfreien Systems verbessert. Es hat sich ergeben, dass die Performance beispielsweise auf eine Größenordnung von 0.1 % bis 1 % der Linienbreite (critical dimension, CD) verbessert werden kann.

Gemäß einem weiteren Aspekt der Erfindung ist vorgesehen, zusätzliche Randbedingungen, beispielsweise über die mögliche Position der Pupillenspots und/oder über eine Mindestanzahl der Pupillenspots, bei der Anpassung des Beleuchtungssettings zu berücksichtigen.

Gemäß einem weiteren Aspekt der Erfindung werden bei der Bestimmung der Funktion zur Charakterisierung der Abhängigkeit der Performancegröße von einer Änderung der Intensitätsverteilung der Beleuchtungsstrahlung in der Beleuchtungspupille eine oder mehrere vorgegebene Maskenstrukturen und/oder Charakteristika, insbesondere Form und/oder Größe und/oder Anordnung, von einer oder mehrerer Aperturblenden der Projektionsoptik und/oder ein Durchmesser eines Beleuchtungsbündels mit Beleuchtungsstrahlung berücksichtigt.

Erfindungsgemäß wurde erkannt, dass diese Details einen wesentlichen Einfluss auf den Verlauf der Begrenzungskanten zwischen Bereichen unterschiedlicher Sensitivität haben.

Gemäß einem weiteren Aspekt der Erfindung wird zur Anpassung der Beleuchtungspupille eine Verteilung und/oder Intensität einer Mehrzahl von Pupillenspots angepasst.

Die Pupillenspots können insbesondere aus Randbereichen zwischen Regionen unterschiedlicher Sensitivität in Bereiche konstanter Sensitivität verlagert werden. Dies ist beispielsweise über eine Verlagerung der ersten Facetten, das heißt im Falle von diskreten zweiten Facetten durch eine entsprechende Auswahl der Beleuchtungskanäle möglich. Im Falle von virtuellen Facetten, insbesondere Facetten mit einer Mehrzahl separater Teilfacetten, ist dies sehr flexibel möglich. Es ist auch möglich, Facettenelemente, welche im Bereich der Begrenzungskanten von Bereichen konstanter Sensitivität angeordnet sind, derart zu verlagern, dass die auf die auftreffende Beleuchtungsstrahlung nicht mehr zum Objektfeld geführt wird.

Gemäß einem weiteren Aspekt der Erfindung ist vorgesehen, zur Anpassung der Beleuchtungspupille eine Mehrzahl von Pupillenspots zu verlagern. Die Pupillenspots werden insbesondere ausgehend von einer vorgegebenen Anordnung (default setting) verlagert.

Gemäß einem Aspekt der Erfindung ist insbesondere vorgesehen, zur Verlagerung der Pupillenspots eine Mehrzahl von Einzelspiegeln des ersten und/oder des zweiten Facettenspiegels der Beleuchtungsoptik zu verlagern.

Gemäß einem weiteren Aspekt der Erfindung wird zur Anpassung der Beleuchtungspupille die Beleuchtungspupille als Ganzes verdreht und/oder verschoben. Sie wird insbesondere relativ zur optischen Achse, das heißt um die optische Achse, verdreht und/oder senkrecht hierzu verschoben.

Es kann insbesondere vorgesehen sein, die Beleuchtungspupille relativ zur Ausrichtung des Retikels zu verdrehen und/oder zu verschieben.

Erfindungsgemäß wurde erkannt, dass es hierdurch möglich ist, die Anzahl der Pupillenspots, welche im Bereich einer Kante zwischen Bereichen unterschiedlicher Sensitivität liegen, zu verringern. Es ist insbesondere möglich, zu vermeiden, dass Achsen einer Gitterstruktur, auf welcher die Pupillenspots angeordnet sind, mit einer Orientierung von Kanten, welche durch Beugung der Beleuchtungsstrahlung an den Strukturen des Retikels und/oder der Aperturblende der Abbildungsoptik entstehen, zusammenfallen.

Eine derartige Verdrehung und/oder Verschiebung der Beleuchtungspupille kann durch eine entsprechende Auslegung der Hardware, insbesondere des Pupillenfacettenspiegels vorgegeben und damit im System verankert werden. Im Falle einer Auslegung des Pupillenfacettenspiegels mit schaltbaren Facetten, insbesondere im Falle einer Auslegung des Pupillenfacettenspiegels als MEMS-MMA, ist auch eine dynamische Ausrichtung der Beleuchtungspupille relativ zur Ausrichtung des Retikels, insbesondere eine Verdrehung und/oder Verschiebung der Beleuchtungspupille, relativ zur Ausrichtung des Retikels möglich. Im Falle einer Beleuchtungsoptik mit einem spekularen Reflektor, ist eine Bewegung der Pupille sogar pixelweise möglich, wobei ein Pixel durch die kleinste MEMS-Einheit gegeben ist.

Die Beleuchtungspupille kann insbesondere durch eine Drehung des Pupillenfacettenspiegels um wenige Grad angepasst werden. Der Pupillenfacettenspiegel kann insbesondere in einem Winkelbereich von bis zu 5 ° verdreht werden. Größere Drehungen lassen sich durch einen Settingwechsel emulieren. Ein derartiger Settingwechsel kann wie eine globale Drehung wirken.

Gemäß einem weiteren Aspekt der Erfindung, insbesondere ein software- und/oder rechnerunterstütztes Optimierungsverfahren, wird zur Anpassung der Beleuchtungspupille ein Optimierungsverfahren verwendet.

Gerade bei einer großen Anzahl von Pupillenspots gibt es in der Regel viele unterschiedliche Möglichkeiten, die Beleuchtungspupille, das heißt das Beleuchtungssetting, an die vorhergehend beschriebene Norm, insbesondere an den Verlauf der Begrenzungskanten zwischen Bereichen unterschiedlicher Sensitivität, anzupassen. Durch Verwendung eines Optimierungsverfahrens können besonders vorteilhafte Beleuchtungspupillen, gegebenenfalls unter Berücksichtigung zusätzlich vorgegebener Randbedingungen, ermittelt werden.

Zur Durchführung des Optimierungsverfahrens kann eine Steuereinheit, insbesondere eine rechnerunterstützte Steuereinheit, vorgesehen sein.

Gemäß einem weiteren Aspekt der Erfindung ist vorgesehen, zur Anpassung der Beleuchtungspupille eine Anordnung von Facetten auf einem Facettenspiegel derart an die vorhergehend beschriebene Norm anzupassen, dass zumindest eine Teilmenge der Facettenspiegel einen vorgegebenen Mindestabstand (dₘᵢₙ) zu Bereichen aufweist, in welchen die Norm größer ist als ein vorgegebener Maximalwert.

Aufgrund des Mindestabstands der Facetten von den Kantenbereichen kann sichergestellt werden, dass die ausgewählten Performancegrößen robust gegenüber Schwankungen der Beleuchtungsstrahlung sind. Der Mindestabstand kann insbesondere in Abhängigkeit von der Größe der zu erwartenden Schwankung der Beleuchtungsstrahlung gewählt werden. Der Mindestabstand (dₘᵢₙ) kann insbesondere mindestens 100 µm, insbesondere mindestens 200 µm, insbesondere mindestens 300 µm, insbesondere mindestens 500 µm, insbesondere mindestens 1 mm, insbesondere mindestens 1cm betragen. Der Mindestabstand (dₘᵢₙ) entspricht insbesondere der Summe des Spotdurchmessers des Bildes der Strahlungsquelle im Zwischenfokus und der zu erwartenden Störungsamplitude desselben, wobei diese Größen bereits im Pupillenfacetten-Koordinatensystem zu betrachten sind. Hierbei ist die Störungsamplitude durch die Größe der Pupillenfacetten beschränkt.

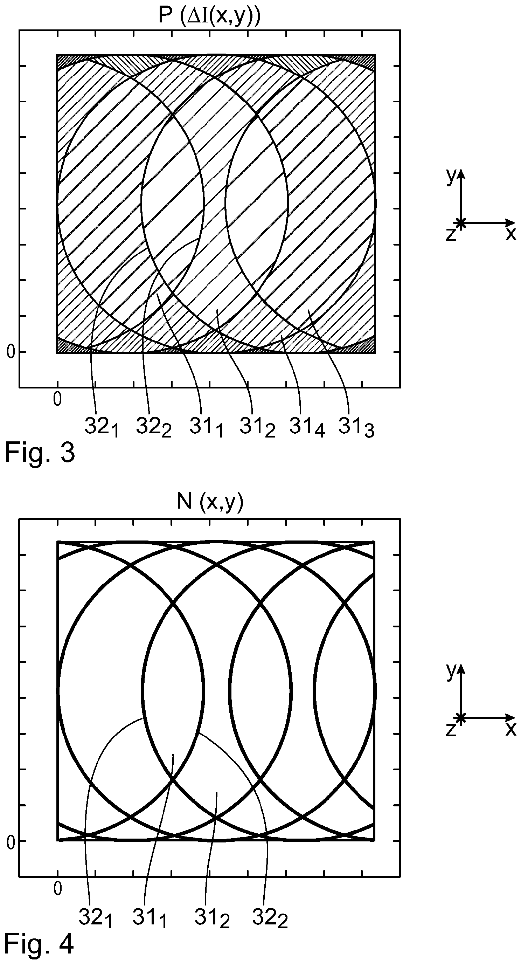

Gemäß einem weiteren Aspekt der Erfindung wird bei einem Verfahren zur Auslegung eines Pupillenfacettenspiegels zunächst ein bestimmtes Feature der Strukturen selektiert. Sodann wird die für diese Größe relevante Kante zwischen Bereichen konstanter Sensitivität ausgesucht und sichergestellt, dass sämtliche Pupillenfacetten einen vorgegebenen Mindestabstand zu dieser Kante aufweisen. Dies führt dazu, dass bei einer invertierten Betrachtung sämtliche Pupillenspots einen Mindestabstand dₘᵢₙ zu den Bildern nullter Beugungsordnung jeglicher Kante von obskurierten Regionen der Abbildungsapertur einhalten, insbesondere wenn das Beugungslimit durch die Maskenstruktur und auf dem Retikel nicht erreicht wird. Das Bild der nullten Beugungsordnung der Abbildungsapertur einer ansonsten obskurationsfreien Abbildungsapertur entspricht beispielsweise in Figur 4 dem zentrierten vollständigen Kreis.

Eine entsprechende Anordnung der Pupillenspots ist besonders vorteilhaft, da das Bild der nullten Beugungsordnung unabhängig von den Details der Maskenstrukturen auf dem Retikel ist.

Gemäß einem weiteren Aspekt der Erfindung wird das Beleuchtungssetting während der Belichtung eines Wafers angepasst. Es kann insbesondere inline, das heißt beim Betrieb der Projektionsbelichtungsanlage, angepasst, insbesondere dynamisch angepasst werden. In einer bevorzugten Variante ist vorgesehen, einen oder mehrere Sensoren zur Erfassung von Schwankungen der Beleuchtungsstrahlung vorzusehen. Die Sensoren können insbesondere im Bereich der Pupillenebene oder einer hierzu konjugierten Ebene oder im Bereich der Objektebene angeordnet sein. Sie sind vorzugsweise in signalübertragender Weise mit der Steuereinrichtung zur Anpassung des Beleuchtungssettings verbunden.

Eine derartige, dynamische Anpassung des Beleuchtungssettings ist insbesondere in Verbindung mit einem Beleuchtungssystem mit variablen Facetten, insbesondere mit virtuellen Facetten, insbesondere mit Facetten, welche durch ein Mikrospiegelarray (MMA, Micro Mirror Array), insbesondere ein mikroelektromechanisches MMA (MEMS-MMA, microelectromechanical system MMA) realisiert sind, vorteilhaft.

Gemäß einem weiteren Aspekt der Erfindung wird zur Anpassung des Beleuchtungssettings ein Koordinatensystem für ein Prozessfenster definiert, bei welchem mindestens eine Koordinate einen oder mehrere systeminterne Parameter des Beleuchtungssystems berücksichtigt, und das Beleuchtungssystem derart angepasst, dass das Prozessfenster in Richtung dieser mindestens einen Koordinate vergrößert wird.

Als Prozessfenster wird hierbei ein mehrdimensionaler Parameterbereich bezeichnet, in welchem ein Fehler der Performance des Beleuchtungssystems, insbesondere eine Abweichung des Parameters (P) von einem Sollwert, höchstens so groß ist wie ein vorgegebenes Limit.

Es ist insbesondere möglich, auf der entsprechenden Koordinate, insbesondere auf der entsprechenden Achse des Koordinatenraums des Prozessfensters die Driftamplitude der Beleuchtungsspots aufzutragen. Durch Vermeiden der Anordnung von Beleuchtungsspots in bestimmten, vorgegebenen, sogenannten verbotenen Zonen, kann das Prozessfenster in Richtung dieser Achse vergrößert werden. Es ist auch möglich, das Prozessfenster in Richtung mehrerer Achsen zu vergrößern.

Weitere Aufgaben der Erfindung bestehen darin, eine Beleuchtungsoptik und ein Beleuchtungssystem für eine Projektionsbelichtungsanlage und eine Projektionsbelichtungsanlage zu verbessern.

Diese Aufgaben werden jeweils durch eine Beleuchtungsoptik mit einem Facettenspiegel gelöst, bei welchem zumindest eine Teilmenge der Facetten derart angeordnet ist, dass sie von vorgegebenen Bereichen jeweils einen Mindestabstand aufweisen beziehungsweise dadurch, dass die einstellbaren Beleuchtungssettings gemäß der vorhergehenden Beschreibung anpassbar sind. Zur Anpassung der Beleuchtungssettings ist eine Steuereinrichtung vorgesehen.

Es ist möglich, dass einzelne Facetten nicht zur Beleuchtung des Objektfeldes benutzt werden.

Die Beleuchtungsoptik umfasst insbesondere zwei Facettenspiegel, wobei die Facetten des zweiten Facettenspiegels gemäß der vorhergehenden Beschreibung angeordnet sind.

Gemäß einem Aspekt der Erfindung ist die Steuereinrichtung derart ausgebildet, dass sie mit einem Speicher, in welchem Werte der vorhergehend beschriebenen Norm hinterlegt sind, in datenübertragender Weise verbunden ist. Hierdurch wird die Anpassung des Beleuchtungssettings erleichtert.

Bei der Strahlungsquelle handelt es sich insbesondere um eine EUV-Strahlungsquelle, das heißt um eine Strahlungsquelle zur Erzeugung von Beleuchtungsstrahlung im EUV-Wellenlängenbereich.

Eine weitere Aufgabe der Erfindung besteht darin, ein Verfahren zur Herstellung eines mikro- oder nanostrukturierten Bauelements zu verbessern. Diese Aufgabe wird durch Anpassen des Beleuchtungssettings zur Beleuchtung des Objektfeldes gemäß der vorhergehenden Beschreibung gelöst. Die Vorteile ergeben sich aus den vorhergehend beschriebenen.

Weitere Vorteile, Details und Einzelheiten der Erfindung ergeben sich aus der Beschreibung von Ausführungsbeispielen anhand der Zeichnungen. Es zeigen:
- Fig. 1: schematisch den Aufbau einer Projektionsbelichtungsanlage für die Mikrolithographie,
- Fig. 2: eine schematische Darstellung des Strahlengangs in einer Projektionsbelichtungsanlage gemäß Fig. 1,
- Fig. 3: schematisch eine Darstellung der Abhängigkeit einer Performancegröße P als Funktion einer Intensitätsänderung ΔI (x,y) der Beleuchtungsstrahlung in der Beleuchtungspupille,
- Fig. 4: schematisch die Norm N einer Richtungsableitung der in der Fig. 3 dargestellten Funktion,
- Fig. 5: eine entsprechende Darstellung wie in Fig. 4 für eine andere Maskenstruktur,
- Fig. 6: schematisch eine vereinfachende Aufteilung der Beleuchtungspupille in insensitive und damit erlaubte Bereiche und sensitive und damit verbotene Bereiche,
- Fig. 7: exemplarische Darstellungen zweier Verteilungen von Beleuchtungsspots in einem Ausschnitt der Beleuchtungspupille,
- Fig. 8: Sensitivität einer ausgewählten Performancegröße (CD-Fehler) bezüglich statistischer geometrischer Schwankungen der Beleuchtungsspots der Beleuchtungspupille jeweils vor Optimierung der Position der Beleuchtungsspots (Kreise) und nach einer Optimierung unter Berücksichtigung der verbotenen Bereiche (Quadrate); entlang der x-Achse sind jeweils unterschiedliche, unabhängige, statistisch gestörte Schwankungen entsprechender Verteilungen der Beleuchtungsspots aufgetragen,
- Fig. 9: exemplarische Darstellungen einer ungünstigen Ausrichtung eines Pupillengrids,
- Fig. 10: schematisch und exemplarisch eine angepasste Ausrichtung des Pupillengrids gemäß Fig. 9,

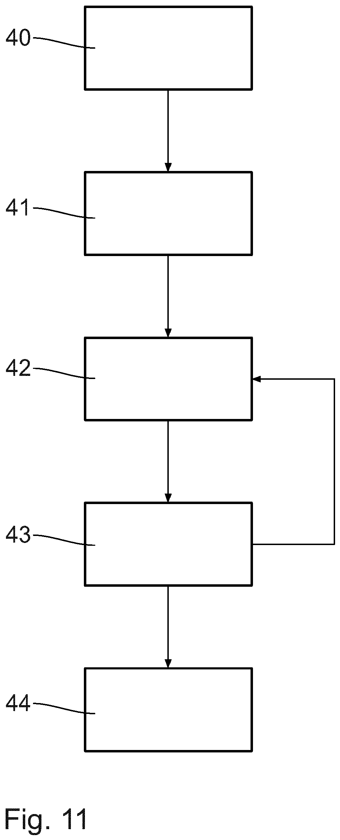

- Fig. 11: schematisch ein Verfahren zur Anpassung der Beleuchtungspupille und
- Fig. 12: schematisch ein Bild einer obskurierten Apertur der Projektionsoptik betrachtet aus der Beleuchtungspupille.

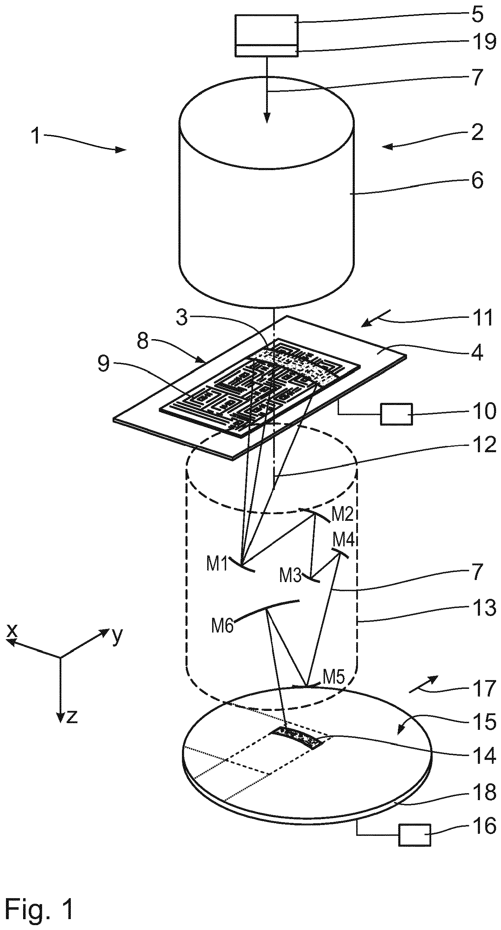

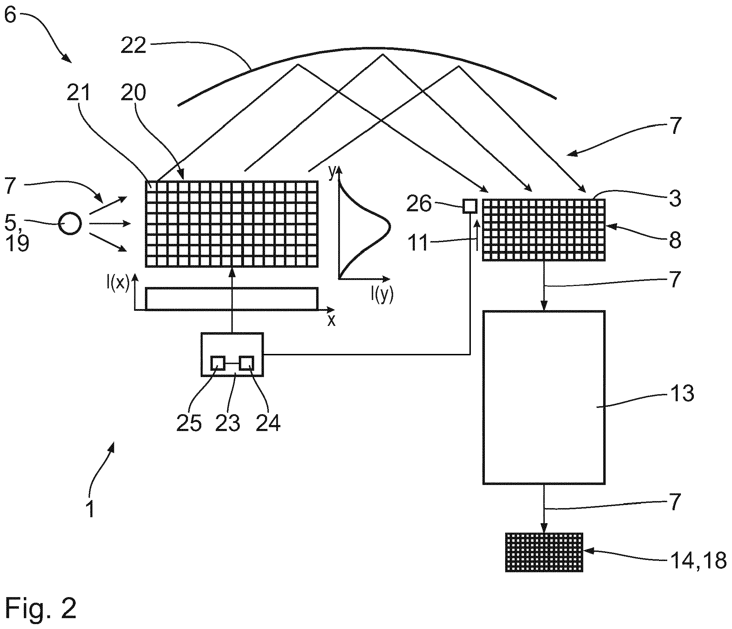

Zunächst werden unter Bezugnahme auf die Fig. 1 und 2 allgemeine Details des Aufbaus und der Bestandteile einer Projektionsbelichtungsanlage 1 beschrieben.

Fig. 1 zeigt in einer sehr schematischen Darstellung den prinzipiellen Aufbau einer Projektionsbelichtungsanlage 1 für die Mikrolithographie. Die Projektionsbelichtungsanlage 1 umfasst ein Beleuchtungssystem 2 zur Beleuchtung eines Objektfeldes 3 in einer Objektebene 4. Das Beleuchtungssystem 2 umfasst eine Strahlungsquelle 5 und eine Beleuchtungsoptik 6 zur Überführung von Beleuchtungsstrahlung 7 von der Strahlungsquelle 5 in das Objektfeld 3. Die Strahlungsquelle 5 kann mit einem Kollektor 19 zur Strahlformung versehen sein. In der Objektebene 4 ist eine auch als Retikel bezeichnete Maske 8 mit abzubildenden Strukturen 9 angeordnet. Die Maske 8 ist von einem Retikelhalter 10 gehalten. Sie ist insbesondere mit Hilfe des Retikelhalters 10 in einer Scanrichtung 11 verlagerbar.

Der Einfachheit halber ist ein kartesisches xyz-Koordinatensystem eingezeichnet. Die y-Richtung desselben ist parallel zur Scanrichtung 11. Die Objektebene 4 ist parallel zur xy-Ebene. Die z-Richtung ist parallel zu einer optischen Achse 12 der Projektionsbelichtungsanlage 1.

Außerdem umfasst die Projektionsbelichtungsanlage 1 eine Projektionsoptik 13 zur Projektion des Objektfeldes 3 in ein Bildfeld 14 in einer Bildebene 15. In der Bildebene 15 ist ein mittels eines Waferhalters 16 in einer Scanrichtung 17 verlagerbaren Wafer 18 gelagert. Mit Hilfe der Projektionsoptik 13 werden die Strukturen 9 des Retikels 8 auf den Wafer 18 abgebildet. Der Wafer 18 ist mit einer strahlungsempfindlichen Beschichtung versehen, welche nach der Beleuchtung entwickelt wird.

Während in der Fig. 1 eine Projektionsbelichtungsanlage 1 dargestellt ist, bei welcher das Retikel 8 durchleuchtet wird, ist es ebenso möglich, das Retikel 8 reflektiv auszubilden und im Reflexionsmodus zu verwenden. Dies ist insbesondere dann vorgesehen, wenn als Strahlungsquelle 5 eine EUV-Strahlungsquelle dient. In diesem Fall kann die Projektionsbelichtungsanlage 1, insbesondere die Beleuchtungsoptik 6 und die Projektionsoptik 13, katoptrisch, d. h. rein reflektiv, ausgebildet sein. Im allgemeinen Fall kann die Projektionsbelichtungsanlage 1, insbesondere die Beleuchtungsoptik 6 und/oder die Projektionsoptik 13 auch dioptrisch oder katadioptrisch ausgebildet sein.

Die Projektionsoptik 13 umfasst eine Mehrzahl von Projektionsspiegeln Mᵢ, welche ausgehend vom Objektfeld 3 in Strahlungsrichtung durchnummeriert werden. M₁ bezeichnet somit den Projektionsspiegel, welcher in Strahlungsrichtung an erster Stelle nach dem Objektfeld 3 angeordnet ist, M₂ den zweiten Spiegel und so weiter. Die Projektionsoptik 13 umfasst sechs Projektionsspiegel M₁ bis M₆. Sie umfasst allgemein insbesondere mindestens vier, insbesondere mindestens sechs, insbesondere mindestens acht Projektionsspiegel Mᵢ.

Für weitere Details der Projektionsbelichtungsanlage 1 und der Komponenten derselben sei auf die WO 2004/092844 A2 und die WO 2009/026947 A1 verwiesen, welche beide vollständig Bestandteil der vorliegenden Anmeldung sein sollen.

Im Folgenden werden weitere Details der Beleuchtungsoptik 6 und eines Verfahrens zur Beleuchtung des Objektfeldes 3 sowie des Bildfeldes 14 mit einem vorbestimmten Beleuchtungssetting beschrieben.

In Fig. 2 ist noch einmal sehr schematisch ein Strahlengang der Beleuchtungsstrahlung 7 in der Projektionsbelichtungsanlage 1 dargestellt. Wie in Fig. 2 exemplarisch verdeutlicht ist, umfasst die Beleuchtungsoptik 6 mindestens eine Spiegeleinheit 20 mit einer Vielzahl von Einzelspiegeln 21. Die Beleuchtungsoptik 6 umfasst außerdem mindestens ein weiteres optisches Element 22. Das mindestens eine weitere optische Element 22 dient der Abbildung der Spiegeleinheit 20 in das Objektfeld 3 in der Objektebene 4, in welcher das Retikel 8 angeordnet ist. Bei der Abbildung handelt es sich insbesondere um eine verkleinernde Abbildung.

Allgemein bildet die Spiegeleinheit 20 ein erstes facettiertes Element, insbesondere einen ersten Facettenspiegel, insbesondere einen Feldfacettenspiegel, mit einer Vielzahl von Facetten.

Das optische Element 22 bildet allgemein ein zweites facettiertes Element, insbesondere einen zweiten Facettenspiegel, insbesondere einen Pupillenfacettenspiegel. Es kann insbesondere ebenfalls eine Vielzahl von Facetten aufweisen. Für Details der doppelt facettierten Ausbildung der Beleuchtungsoptik 6 sowie insbesondere der facettierten Elemente sei beispielsweise auf die WO 2009/0269547 A1 und die WO 2012/130 768 A2 verweisen, welche vollständig Bestandteil der vorliegenden Anmeldung sein soll.

Die Spiegeleinheit 20 ist als mikroelektromechanisches System (MEMS) ausgebildet. Für Details sei wiederum auf die WO 2009/0269547 A1 verwiesen. Es ist jedoch auch möglich, die Spiegeleinheit 20 mit monolithischen Einzelspiegeln 21 auszubilden.

Die Spiegeleinheit 20 umfasst insbesondere Nₓ Spalten und N_{y} Zeilen an Einzelspiegeln 21. Die Anzahl N_{y} der Zeilen ist beträgt vorteilhafterweise zwischen 30 und 500, insbesondere zwischen 50 und 250. Besonders vorteilhaft kann eine Anzahl zwischen 75 und 150 sein.

Das Aspektverhältnis der Spiegeleinheit 20, insbesondere die Anzahl Nₓ : N_{y}, entspricht insbesondere gerade dem Aspektverhältnis des Objektfeldes und/oder dem des Bildfeldes. Das Aspektverhältnis ist insbesondere größer als 4:1, insbesondere größer als 10:1.

Bei den Einzelspiegeln 21 handelt es sich insbesondere um Mikrospiegel, insbesondere mit einer Reflexionsfläche im Bereich von 10⁻¹⁰ m² bis 10⁻⁴ m², insbesondere im Bereich von 10⁻⁸ m² bis 10⁻⁶ m², insbesondere im Bereich 10⁻⁷ m² bis 10⁻⁶ m².

Die Einzelspiegel 21 sind zwischen unterschiedlichen Verlagerungspositionen gesteuert verlagerbar. Die Einzelspiegel 21 können kontinuierlich verlagerbar sein. Es ist ebenso möglich, die Einzelspiegel 21 mit diskreten Verlagerungspositionen auszubilden. Zur Steuerung der Verlagerung der Einzelspiegel 21 ist eine Steuereinrichtung 23 vorgesehen.

Die Einzelspiegel 21 sind insbesondere verschwenkbar gelagert. Sie können insbesondere einen oder zwei Schwenkfreiheitsgrade aufweisen. Sie sind insbesondere um Schwenkachsen, welche parallel zur xy-Ebene verlaufen, verschwenkbar. Sie können auch höhenverstellbar, d. h. in z-Richtung linear verlagerbar sein.

Die Steuereinrichtung 23 umfasst einen Prozessor 24, mittels welchem die Auswahl der Verlagerungspositionen der Einzelspiegel 21 zur Einstellung eines bestimmten Beleuchtungssettings gemäß einem Optimieralgorithmus optimierbar ist. Das Verfahren zur Einstellung eines bestimmten Beleuchtungssettings wird nachfolgend noch näher beschrieben.

Außerdem umfasst die Steuereinrichtung 23 eine Speichereinheit 25. In der Speichereinheit 25 können unterschiedliche Einstellungen der Einzelspiegel 21 gespeichert sein. Es ist insbesondere möglich, unterschiedliche Beleuchtungssettings, welche mit dem Beleuchtungssystem 2 einstellbar sind, in der Speichereinheit 25 abzulegen. Diese sind dann besonders einfach, insbesondere besonders schnell abrufbar.

Außerdem können Ausnahmepositionen der Einzelspiegel 21 gespeichert werden. Eine Ausnahmeposition ist hierbei eine prinzipiell mögliche Verlagerungsposition eines Einzelspiegels 21, welche jedoch gezielt von den einstellbaren Verlagerungspositionen ausgenommen ist. Es handelt sich mit anderen Worten um verbotene Stellungen, die der jeweilige Einzelspiegel 21 nicht annehmen soll.

Die Speichereinheit 25 ist vorzugsweise programmierbar. Sie ist in datenübertragender Weise mit dem Prozessor 24 verbunden.

Im Folgenden werden Details eines Verfahrens zur Beleuchtung des Objektfeldes 3, insbesondere eines Verfahrens zur Einstellung eines Beleuchtungssettings der Beleuchtungsoptik 6, beschrieben. Als Beleuchtungssetting wird hierbei die Gesamtheit der zur Beleuchtung des Objektfeldes 3 verwendeten Beleuchtungskanäle bezeichnet. Ein Beleuchtungskanal wird jeweils durch Zuordnung einer Facette des ersten Facettenspiegels zu einer Facette des zweiten Facettenspiegels gebildet. Diese Zuordnung ist einstellbar. Sie ist insbesondere veränderbar. Sie kann insbesondere mittels der Steuereinrichtung 23 verändert werden. Allgemein können sowohl die Facetten des ersten Facettenspiegels als auch die Facetten des zweiten Facettenspiegels verlagerbar, insbesondere verschwenkbar sein. Hierdurch ist eine variable Einstellung, insbesondere eine Steuerung des Beleuchtungssettings möglich. Insbesondere die Facetten des zweiten Facettenspiegels können auch fix, das heißt nicht-verlagerbar, ausgebildet sein.

Zur Charakterisierung der Qualität der Beleuchtung des Objektfeldes 3 kann ein Parameter P dienen, welcher auch als Performancegröße bezeichnet wird. Entsprechende Performancegrößen sind beispielsweise die Linienbreite (Critical Dimension, CD) beziehungsweise deren Uniformität (CD-Uniformität, CDU), Overlay, Imaging-Telezentrie, HV-Peformance, Line Edge Roughness, Line Width Roughness, Tip-to-Tip-Abstände kritischer Features, (18) Kantensteilheit (Normalized Image Log Slope, NILS), Kontrast.

Die Performancegröße ist im Allgemeinen abhängig von den Eigenschaften der Komponenten der Projektionsbelichtungsanlage 1, insbesondere des Beleuchtungssystems 2 und der Projektionsoptik 13. Sie ist insbesondere auch abhängig vom Beleuchtungssetting, welches zur Beleuchtung des Retikels 8 verwendet wird. Diesbezüglich wurde erkannt, dass selbst kleine Änderungen des Beleuchtungssettings, welche sich in einem realen System insbesondere aufgrund von Schwankungen und/oder Störungen ergeben können, einen erheblichen Einfluss auf die Performancegrößen haben können. Dies führt dazu, dass die tatsächlich realisierten Performancegrößen oftmals deutlich hinter den für ein ideales System ermittelten, bestenfalls erreichbaren Werten erheblich abweichen.

In der Fig. 3 ist exemplarisch die Abhängigkeit einer Performancegröße von einer Intensitätsänderung ΔI (x,y) der Beleuchtungsstrahlung 7 in der Pupille der Beleuchtungsoptik 6, insbesondere im Bereich des zweiten Facettenspiegels, dargestellt. Diese Darstellung ergibt gleichsam einen Abdruck der Maske 8 und der Beleuchtungsoptik 6 und der Projektionsoptik 13 in der Pupillenebene des Beleuchtungssystems 2.

In der exemplarischen Darstellung der Fig. 3 erkennt man qualitativ eine Plateaubildung für die gewählte Performancegröße P in Abhängigkeit von einer Intensitätsänderung ΔI (x,y) der Beleuchtungsstrahlung 7 in der Pupille. Man erkennt insbesondere unterschiedliche Regionen 31ᵢ, in welchen die Performancegröße eine konstante Sensitivität in Bezug auf Intensitätsänderungen der Beleuchtungsstrahlung 7 in der Pupille aufweist. Anders ausgedrückt stellen die Regionen 31ᵢ Bereiche dar, in welchen eine Verlagerung eines Pupillenspots keinen oder einen höchstens vernachlässigbaren Einfluss auf die betrachtete Performancegröße hat. Die Regionen 31ᵢ sind durch recht scharf berandete Übergangsbereiche 32; voneinander getrennt.

Eine Verlagerung eines Pupillenspots entspricht dem Erzeugen von Intensität an einem Ort und dem Entfernen dieser Intensität an einem benachbarten Ort.

Wie der Fig. 3 qualitativ zu entnehmen ist, sind die Übergangsbereiche 32ᵢ recht schmal ausgebildet. Sie werden daher auch als Kanten bezeichnet. Wird ein Beleuchtungsspot über eine derartige Kante verlagert, ändert sich die Performancegröße im Luftbild. Die Übergangsbereiche 32; sind insbesondere in etwa so breit wie ein Beleuchtungsspot. Sie sind insbesondere in etwa so breit wie die Größe des Plasmabildes in der Pupille.

In der Fig. 4 sind diese Kanten exemplarisch noch einmal deutlicher dargestellt. Hierzu ist in der Fig. 4 die Norm N(x,y) einer Richtungsableitung der Funktion der Abhängigkeit der Performancegröße P von der Änderung der Intensität der Beleuchtungsstrahlung ΔI (x,y) dargestellt. Als Norm N(x,y) dient beispielsweise die Sobelnorm.

Wie man aus der Fig. 4 qualitativ erkennt, ist diese Norm im Bereich der Regionen 31ᵢ nur sehr klein. Sie ist insbesondere zumindest kleiner als ein vorgegebener Maximalwert. Dieser Maximalwert bzw. die Amplitude der Norm kann prinzipiell beliebig sein, muss jedoch von der Apodisierung des Systems noch trennbar sein. Ansonsten wäre die Plateau-Bildung bzw. Kantenbildung nicht erkennbar. In den Übergangsbereichen 32; ist die Norm N(x,y) größer als ein vorgegebener Maximalwert.

Während der sogenannten Source Mask Optimization (SMO, Quellen-Masken-Optimierung) wird die Pupille, das heißt das Beleuchtungssetting, durch Umschalten und/oder Verlagern des Pupillenspots, das heißt durch Auswahl und/oder Verlagerung der Beleuchtungskanäle, derart verändert, dass ein guter Kompromiss zwischen der Prozessfenstergröße und Durchsatz erreicht wird. Hierbei wird die Struktur 9 der zu belichtenden Maske 8 berücksichtigt. Außerdem werden die Eigenschaften der Beleuchtungsoptik 6 und/oder der Projektionsoptik 13 berücksichtigt.

Ein Prozessfenster kommt folgendermaßen zustande. Es gibt ein Limit eines Fehlers einer Performance, beispielsweise 5 % CD-Abweichung, bei welchem das herzustellende Bauelement, beispielsweise ein Chip, gerade noch funktioniert. Da die Erreichung dieses Limits von mehreren Größen abhängig ist, welche unabhängig voneinander variiert werden können, beispielsweise Depth-of-Focus und Dosisschwankungen, wird der mehrdimensionale Parameterbereich, in welchem der Fehler kleiner ist als dieses Limit, als Prozessfenster bezeichnet. Zum Teil wird auch eine Ellipse oder in einem höher dimensionalen Fall eine entsprechende höher dimensionale Verallgemeinerung einer Ellipse, welche gerade so in diesen Bereich hineinpasst, als Prozessfenster bezeichnet.

Eines der Ziele, der Quellen-Masken-Optimierung (Source Mask Optimization, SMO) ist es, das Prozessfenster so groß wie möglich zu machen, so dass Variationen kritischer Größen des Systems minimalen Einfluss auf die Performancegrößen haben.

Anschaulich gesprochen kann das erfindungsgemäße Verfahren im Hinblick auf das Prozessfenster so beschrieben werden, dass als Parameter im Koordinatenraum für das Prozessfenster eine Achse definiert oder hinzugefügt wird, welche systeminterne Parameter berücksichtigt. Beispielsweise kann auf einer derartigen Achse die Driftamplitude der Beleuchtungsspots aufgetragen sein. Durch Vermeiden der Anordnung von Beleuchtungsspots in bestimmten, vorgegebenen, sogenannten verbotenen Zonen, kann das Prozessfenster in Richtung dieser Achse vergrö-ßert werden.

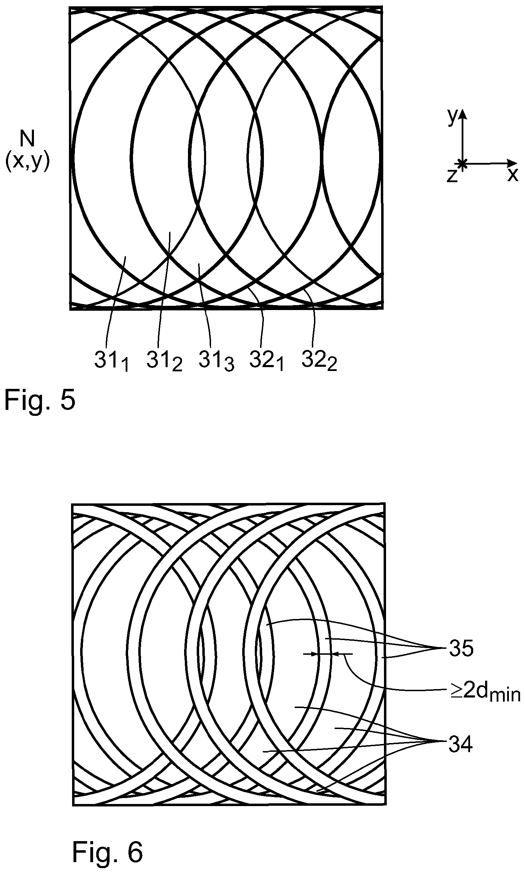

Erfindungsgemäß ist vorgesehen, bei der Quellen-Masken-Optimierung die Position der Übergangsbereiche 32ᵢ zu berücksichtigen. Es ist insbesondere vorgesehen, das Beleuchtungssetting zur Beleuchtung des Objektfeldes 3, insbesondere zur Beleuchtung der Maske 8, an die Werte der Norm N(x,y) anzupassen. Das Beleuchtungssetting wird insbesondere derart an die Norm N(x,y) angepasst, dass höchstens eine maximal zulässige Anzahl an Pupillenspots, insbesondere höchstens 50, insbesondere höchstens 30, insbesondere höchstens 20, insbesondere höchstens 10, insbesondere höchstens 5, insbesondere höchstens 3, insbesondere höchstens 2, insbesondere höchstens 1 Pupillenspots, vorzugsweise kein Pupillenspot mit einem der Übergangsbereiche 32; überlappt. Die Pupillenspots weisen insbesondere vorzugsweise einen vorgegebenen Mindestabstand dₘᵢₙ zu den Übergangsbereichen 32; auf. Dies ist in der Fig. 6 noch einmal exemplarisch verdeutlicht. Fig. 5 zeigt eine Darstellung der Norm N(x,y) entsprechend der Darstellung gemäß Fig. 4, jedoch für eine Maske 8 mit einer alternativen Struktur 9. In der Fig. 6 ist die Pupille entsprechend der Lage und Ausdehnung der Regionen 31ᵢ beziehungsweise der Übergangsbereiche 32ᵢ in erlaubte Bereiche 34 und verbotene Bereiche 35 aufgeteilt. Die verbotenen Bereiche 35 weisen hierbei jeweils eine Breite von mindestens 2 dₘᵢₙ auf.

Die verbotenen Bereiche 35 sind die Bereiche, in welchen eine Schwankung der Beleuchtungsstrahlung 7 zu einem erheblichen Einfluss auf die Performancegröße führen würde. Diese Bereiche werden daher gemäß dem Verfahren zur Einstellung eines Beleuchtungssettings von den Pupillenspots vorzugsweise vermieden. Anders ausgedrückt, wird das Beleuchtungssetting derart am die Bereiche 34, 35 angepasst, dass die Mehrzahl der Beleuchtungsspots, insbesondere mindestens 60 %, insbesondere mindestens 70 %, insbesondere mindestens 80 %, insbesondere mindestens 90 %, insbesondere mindestens 95 %, vorzugsweise sämtliche Beleuchtungsspots in erlaubten Bereichen 34 liegen.

Dies kann entweder bereits bei der Auslegung des Beleuchtungssystems 2, insbesondere bei der Auslegung des Pupillenfacettenspiegels geschehen.

Bei der Auslegung des Pupillenfacettenspiegels können insbesondere obskurierte Bereiche der Projektionsoptik berücksichtigt werden. Der Pupillenfacettenspiegel kann insbesondere derart ausgelegt werden, dass keine der Pupillenfacetten derart angeordnet ist, dass sie zu einem Strahlengang der Beleuchtungsstrahlung führt, welcher in der Projektionsoptik in den Bereich einer Kante einer obskurierten Region fällt. Bei einer invertierten Betrachtungsweise entspricht dies einer Anordnung, so dass sämtliche der Pupillenfacetten einem Mindestabstand vom Bild der nullten Beugungsordnung der Apertur der Projektionsoptik bei Beugung an den Strukturen des Retikels aufweisen. Das Bild der nullten Beugungsordnung ist hierbei unabhängig von der Struktur des Retikels. Eine entsprechende Ausbildung des Pupillenfacettenspiegels führt somit zu verbesserten optischen Eigenschaften unabhängig von der Struktur des Retikels.

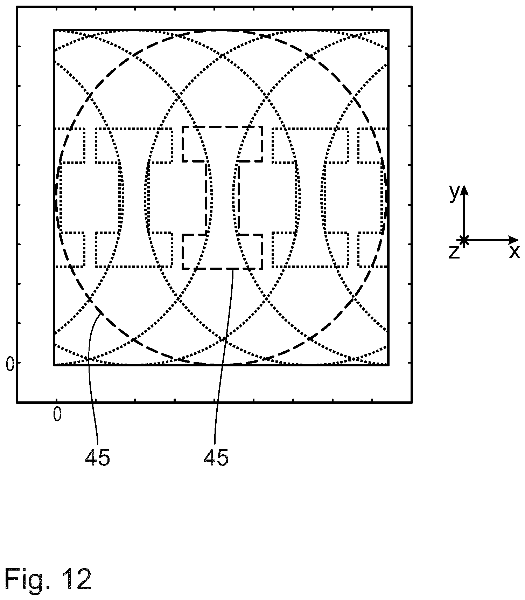

Die Pupillenfacetten sind somit derart auf dem Pupillenfacettenspiegel angeordnet, dass es mindestens einen einfach wegzusammenhängenden Bereich gibt, in welchem keine Pupillenfacetten angeordnet sind, wobei die Form dieses Bereichs einer Umrandung einer Obskuration der Apertur der Projektionsoptik entspricht, insbesondere gerade ein skaliertes Bild 45 der Berandung einer derartigen Obskuration ist, und wobei dieser Bereich an jeder Stelle eine Mindestbreite aufweist, welche dem oben beschriebenen Mindestabstand einer Facette von einem Kantenbereich entspricht. Dies ist exemplarisch und schematisch in der Fig. 12 dargestellt. In der Fig. 12 ist insbesondere als gestrichelte Linie markiert die masken-strukturunabhäng-ige Abtastung der Apertur der Projektionsoptik mit der nullten Beugungsordnung der Beleuchtungspupille. Die gestrichelten Linien entsprechen insbesondere gerade dem Bild 45 der Berandung eines obskurierten Bereichs der Projektionsoptik. Höhere Beugungsordnungen des Bildes 45 der Berandung sind in der Figur 12 gepunktet dargestellt.

Im Falle von verlagerbaren, insbesondere gesteuert verlagerbaren Facetten kann eine derartige Anpassung auch in einer fertigen Projektionsbelichtungsanlage 1 vorgenommen werden. Gemäß einer vorteilhaften Alternative kann die Anpassung auch während des Betriebs der Projektionsbelichtungsanlage 1 vorgenommen werden. Es ist insbesondere möglich, Onlineschwankungen der Beleuchtungsstrahlung, insbesondere geometrische Schwankungen derselben und/oder Störungen, beispielsweise Schwingungen der Komponenten der Projektionsbelichtungsanlage 1, online zu berücksichtigen. Zur Erfassung entsprechender Schwankungen und/oder Störungen ist ein Sensor 26 vorgesehen, welcher in signalübertragender Weise mit der Steuereinrichtung 23 verbunden ist. Der Sensor 26 kann insbesondere im Bereich der Objektebene 4 angeordnet sein. Er kann auch im Bereich des optischen Elements 22 angeordnet sein. Alternativen sind ebenfalls möglich.

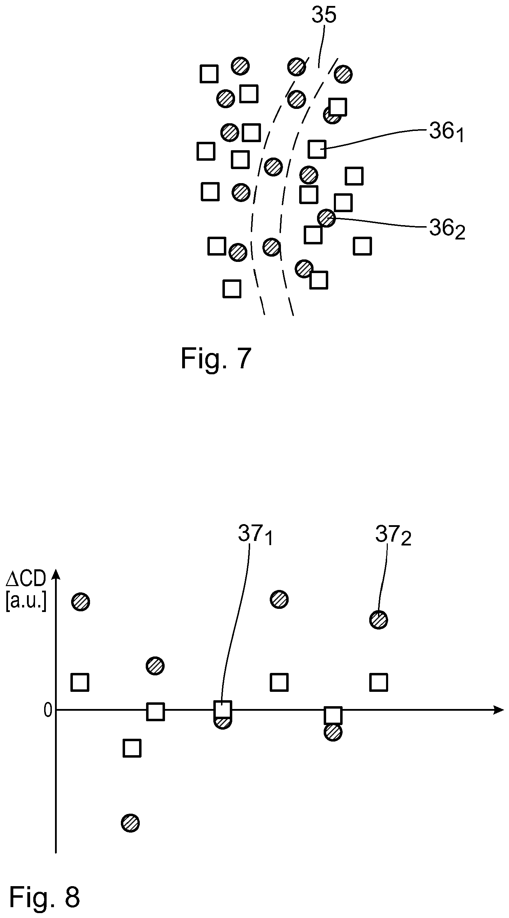

Zur Verdeutlichung der verfahrensgemäß erzielbaren Vorteile ist in Fig. 7 exemplarisch ein Ausschnitt aus einer Beleuchtungspupille mit unterschiedlichen Verteilungen der Pupillenspots 36₁, 36₂ sowie in Fig. 8 die Abweichung ΔCD der Linienbreite CD zur Solllinienbreite 37₁, 37₂ der entsprechenden Beleuchtungspupillen in Bezug auf statistische, geometrische Schwankungen der Positionen der Pupillenspots 36₁, 36₂ als spezielles Beispiel für Schwankungen und/oder Störungen der Beleuchtungsstrahlung 7 und/oder der Komponenten der Beleuchtungsoptik 6 dargestellt. Auf der x-Achse der Fig. 8 sind hierbei jeweils diskrete unterschiedlich statistisch geometrisch gestörte Pupillen aufgetragen.

Wie man der Fig. 8 deutlich entnehmen kann, führt die Anordnung der Pupillenspots 36₂ ausschließlich in den erlaubten Bereichen 34 zu einer erheblichen Verbesserung der Abweichung ΔCD für den Fall driftender Beleuchtungsspots.

Die Anordnung der Pupillenspots 36₁, 36₂ kann als Anordnung der zweiten Facetten auf dem zweiten Facettenspiegel verstanden werden. Diese Anordnung kann bei der Auslegung des zweiten Facettenspiegels berücksichtigt werden. Sie kann insbesondere hardwaremäßig vorgegeben werden. Sie kann auch mittels der Steuereinrichtung 23, insbesondere dynamisch, insbesondere softwareunterstützt eingestellt werden.

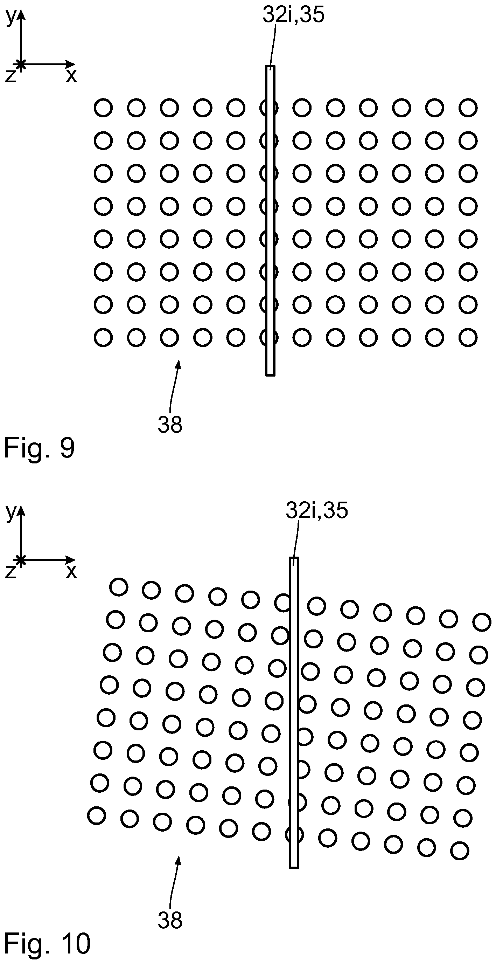

Anhand der Fig. 9 und 10 sei erläutert, wie das Verfahren bereits bei der Auslegung des zweiten Facettenspiegels berücksichtigt werden kann. In den Fig. 9 und 10 ist exemplarisch die relative Lage eines der Übergangsbereiche 32; beziehungsweise eines der verbotenen Bereiche 35 relativ zu einem Pupillengrid 38 dargestellt. Das Pupillengrid 38 gibt schematisch die Anordnung der zweiten Facetten auf dem zweiten Facettenspiegel wieder.

Der Verlauf der verbotenen Bereiche 35 sowie die konkrete Darstellung des Pupillengrids 38 sind schematisch und rein exemplarisch, jedoch nicht einschränkend zu verstehen.

Der Verlauf der Übergangsbereiche 32; ist unter anderem von den Details der Struktur 9 der Maske 8 und von den Details von Aperturblenden der Projektionsoptik 13 abhängig.

In Fig. 9 ist exemplarisch ein ungünstiger Fall dargestellt, bei welchem eine große Anzahl von Pupillenspots, das heißt die Lage der zweiten Facettenelemente mit dem verbotenen Bereich 35 überlappt. Diese Situation kann durch eine Verdrehung des Pupillengrids 38 relativ zum verbotenen Bereich 35, das heißt relativ zur optischen Achse 12, welche mit dem in z-Richtung eingezeichneten Koordinatensystems übereinstimmt, verbessert werden (s. Fig. 10). Das Pupillengrid 38 wird insbesondere relativ zur Ausrichtung der Maske 8, insbesondere relativ zur Ausrichtung der Strukturen 9 der Maske 8, welche als Beugungsstrukturen für die Beleuchtungsstrahlung 7 wirken, verdreht. Das Pupillengrid 38 kann alternativ oder zusätzlich hierzu relativ zur optischen Achse 12, insbesondere in Richtung senkrecht hierzu, insbesondere relativ zur Maske 8, verschoben werden.

Bereits im Falle eines toleranzfreien Systems ist die Anordnung der Pupillenspots relativ zum verbotenen Bereich 35, wie sie exemplarisch in Fig. 10 dargestellt ist, günstiger als die in Fig. 9 dargestellte Variante, da die geometrische Feldvariation eines einzelnen Pupillenspots nur bei den wenigen Spots, die genau auf der Kante liegen, zum Tragen kommt. Für ein toleranzbehaftetes System ist die Anordnung gemäß Fig. 10 insbesondere für eine systematische Störung, beispielsweise einem horizontalen Drift aller Spots, günstiger als die Anordnung gemäß Fig. 9.

Im Folgenden werden weitere Aspekte und Alternativen des erfindungsgemäßen Verfahrens stichwortartig beschrieben. Sie sind gleichermaßen für die unterschiedlichen vorhergehend beschriebenen Alternativen anwendbar.

Zur Anpassung des Beleuchtungssettings können eine oder mehrere Performancegrößen berücksichtigt werden.

Bei der Bestimmung der funktionellen Abhängigkeit der Performancegrößen von der Intensitätsänderung der Beleuchtungsstrahlung 7 in der Beleuchtungspupille können eine oder mehrere konkret vorgegebene Masken 8 mit unterschiedlichen Strukturen 9 und/oder Aperturblenden und/oder Eigenschaften der Beleuchtungsstrahlung 7, insbesondere ein Durchmesser eines Bündels mit Beleuchtungsstrahlung 7, berücksichtigt werden.

Zur Anpassung der Beleuchtungspupille kann ein Optimierungsverfahren verwendet werden. Hierbei können zusätzliche Randbedingungen, beispielsweise eine vorgegebene Mindestanzahl an Pupillenspots, berücksichtigt werden.

Der vorgegebene Mindestabstand dₘᵢₙ der einzelnen Pupillenspots zu den Übergangsbereichen 32; kann in Abhängigkeit von zu erwartenden Schwankungen der Beleuchtungsstrahlung 7 und/oder Störungen der Komponenten der Projektionsbelichtungsanlage 1, insbesondere der Beleuchtungsoptik 6 und/oder der Projektionsoptik 13, bestimmt werden.

Die Anpassung der Beleuchtungspupille muss nicht notwendigerweise exakt in einer Pupillenebene stattfinden. Das zweite facettierte Element kann insbesondere beabstandet zu einer Pupillenebene angeordnet sein. Diese Alternative wird auch als spekularer Reflektor bezeichnet.

Die Anpassung der Beleuchtungspupille kann softwareunterstützt erfolgen. Im Folgenden wird exemplarisch ein Verfahren zur computerunterstützten Anpassung der Beleuchtungspupille beschrieben.

Hierfür müssen zunächst die relevanten Performanceeigenschaften des Luftbildes modelliert werden. Hierfür sind eine Imaging-Simulation oder auch vereinfachte Varianten davon vorgesehen.

Die Modellierung kann auch messtechnisch unterstützt werden. Es ist insbesondere möglich, zuvor gemessene Informationen über das System und/oder das Verfahren zu berücksichtigen. Dies kann insbesondere zur Kalibrierung des Modells und/oder der Simulationstools vorteilhaft sein.

Anschließend werden sämtliche Performancegrößen, die als relevant erachtet werden, auf einen Skalar reduziert. Als Performancegrößen kommen insbesondere die vorhergehend bereits genannten sowie Uniformität der Beleuchtung des Objektfeldes, Transmission, Durchsatz (throughput), klassische Telezentrie und Elliptizität infrage. Die Reduktion der relevanten Peformancegrößen auf einen Skalar kann mit Hilfe einer Merit-Funktion erreicht werden. Beispielsweise können zwei Größen über eine gewichtete Summe ihrer Quadrate zu einem Skalar zusammengefasst werden.

Ziel der Software bzw. des Verfahrens zur Anpassung der Beleuchtungspupille ist es, das Extremum dieser Merit-Funktion zu finden. Hierbei handelt es sich, je nach Formulierung der Problemstellung, oftmals um ein Minimum dieser Funktion.

Die Vermeidung der vorhergehend beschriebenen verbotenen Zonen oder verbotenen Bereiche 35 kann als zusätzliche Bedingung in diesem Optimierungsverfahren berücksichtigt werden.

Bei dem Verfahren handelt es sich insbesondere um ein iteratives Verfahren. Das Verfahren weist insbesondere die folgenden Schritte auf:
Einen Vorgabeschritt 40 zur Vorgabe einer eingestellten Pupille.

Einen Berechnungsschritt 41 zur Ermittlung der verbotenen Bereiche 35.

Einen Bewertungsschritt 42 zur Ermittlung der Merit-Funktion und/oder zur Ermittlung, wie viele der Beleuchtungsspots innerhalb der verbotenen Bereiche 35 liegen oder mit diesen überlappen.

Einen Variierungsschritt 43, bei welchem eine Variation der Beleuchtungspupille derart durchgeführt wird, dass die Merit-Funktion verbessert wird oder zumindest konstant bleibt, und gleichzeitig die Anzahl der Beleuchtungsspots in den verbotenen Bereichen reduziert wird. Nach dem Variierungsschritt kann wieder eine Bewertung mittels des Bewertungsschritts 42 durchgeführt werden. Die Schleife mit dem Bewertungsschritt 42 und dem Variierungsschritt 43 kann solange ausgeführt werden, bis der bestmögliche Kompromiss zwischen dem Merit-Funktionswert und der Anzahl der Beleuchtungsspots in den verbotenen Bereichen 35 erreicht ist.

Sofern notwendig und/oder gewünscht, kann auch der Berechnungsschritt 41 erneut ausgeführt werden. Dies kann sinnvoll sein, sofern sich die Pupille, beispielsweise mehr als 10 % der Beleuchtungsspots, während der Optimierung verändert hat. Durch eine erneute Durchführung des Berechnungsschritts 41 kann sichergestellt werden, dass die Sensitivitätsrechnung zur aktuellen Optimiersituation passt. Sofern ein vorgegebenes Abbruchkriterium erreicht wurde, kann in einem Verifizierungsschritt 44 das Ergebnis noch einmal überprüft werden. Dies kann experimentell oder mittels numerischer Simulationen erfolgen.

Beim Variierungsschritt 43 können gezielt vorgegebene Randbedingungen berücksichtigt werden. Beispielsweise kann vorgegeben werden, dass in vorgegebenen Bereichen der Pupille jeweils Mindest-/Höchstzahlen an Pupillenspots liegen. Außerdem ist es möglich, bestimmte Performanceparameter bei diesem Verfahren besonders zu berücksichtigen.

## Patentansprüche

1. Verfahren zur Einstellung eines Beleuchtungssettings zur Beleuchtung eines Objektfeldes (3) einer Projektionsbelichtungsanlage (1) umfassend die folgenden Schritte:
1.1. Bereitstellen eines Beleuchtungssystems (2) zur Beleuchtung eines Objektfeldes (3) mit Beleuchtungsstrahlung (7),
1.2. Vorgabe mindestens eines Parameters (P) zur Charakterisierung der Qualität der Beleuchtung des Objektfeldes (3),
1.3. Bestimmen einer ortsaufgelösten Funktion P(ΔI(x,y)) der Abhängigkeit des mindestens einen Parameters (P) von einer Änderung der Intensität der Beleuchtungsstrahlung (7) (ΔI(x,y)) in der Beleuchtungspupille,
1.4. Bestimmen einer Norm (N(x, y)) einer Richtungsableitung dieser Funktion P(ΔI(x,y)),
1.5. Anpassen eines Beleuchtungssettings zur Beleuchtung des Objektfeldes (3) an die Norm (N(x, y)).

2. Verfahren gemäß Anspruch 1, **dadurch gekennzeichnet, dass** der mindestens eine Parameter (P) zur Charakterisierung der Qualität der Beleuchtung des Objektfeldes (3) ausgewählt ist aus folgender Liste: Linienbreite (CD, critical dimension), Overlay, Imaging-Telezentrie, CD-Uniformität, HV-Peformance, Line Edge Roughness, Line Width Roughness, Tip-to-Tip-Abstände kritischer Features, Kantensteilheit (NII,S, normalized image log slope), Kontrast.

3. Verfahren gemäß einem der vorhergehenden Ansprüche, **dadurch gekennzeichnet, dass** bei der Bestimmung der Funktion P(ΔI(x,y)) eine oder mehrere vorgegebene Strukturen (9) von Masken (8) und/oder Aperturblenden und/oder ein Durchmesser eines Querschnitts der Beleuchtungsstrahlung (7) berücksichtigt werden.

4. Verfahren gemäß einem der vorhergehenden Ansprüche, **dadurch gekennzeichnet, dass** zur Anpassung der Beleuchtungspupille eine Verteilung und/oder Intensität einer Mehrzahl von Pupillenspots angepasst wird.

5. Verfahren gemäß einem der vorhergehenden Ansprüche, **dadurch gekennzeichnet, dass** zur Anpassung der Beleuchtungspupille eine Mehrzahl von Pupillenspots verlagert wird, indem eine Mehrzahl von Einzelspiegeln (21) eines Facettenspiegels (20, 22) der Beleuchtungsoptik (6) verlagert wird.

6. Verfahren gemäß Anspruch 5, **dadurch gekennzeichnet, dass** zur Anpassung der Beleuchtungspupille die Beleuchtungspupille als Ganzes verdreht und/oder verschoben wird.

7. Verfahren gemäß einem der Ansprüche 1 bis 3, **dadurch gekennzeichnet, dass** zur Anpassung der Beleuchtungspupille eine Anordnung von Facetten auf einem Facettenspiegel derart an die Norm (N(x, y)) angepasst wird, dass zumindest eine Teilmenge der Facettenspiegel einen vorgegebenen Mindestabstand (dₘᵢₙ) zu Bereichen (x, y) aufweist, in welchen die Norm (N(x, y)) größer ist als ein vorgegebener Maximalwert.

8. Verfahren gemäß einem der vorhergehenden Ansprüche, **dadurch gekennzeichnet, dass** das Beleuchtungssetting während der Belichtung eines Wafers (18) angepasst wird.

9. Verfahren gemäß einem der vorhergehenden Ansprüche, **dadurch gekennzeichnet, dass** zur Anpassung des Beleuchtungssettings ein Koordinatensystem für ein Prozessfenster definiert wird, bei welchem mindestens eine Koordinate einem oder mehreren systeminternen Parametern des Beleuchtungssystems (2) entspricht, und das Beleuchtungssetting derart angepasst wird, dass das Prozessfenster in Richtung dieser mindestens einen Koordinate vergrößert wird.

10. Beleuchtungsoptik (6) für eine Projektionsbelichtungsanlage (1) mit
10.1. einem ersten Facettenspiegel mit einer Vielzahl von ersten Facetten und
10.2. einem zweiten Facettenspiegel mit einer Vielzahl von zweiten Facetten,
10.3. wobei jeweils eine der ersten Facetten zur Ausbildung eines Beleuchtungskanals jeweils einer der zweiten Facetten zugeordnet ist oder zugeordnet werden kann,
10.4. wobei die Gesamtheit der derart ausgebildeten Beleuchtungskanäle jeweils ein Beleuchtungssetting zur Beleuchtung eines Objektfeldes (3) bilden, und
10.5. **gekennzeichnet durch** eine Steuereinrichtung, derart ausgebildet, dass die einstellbaren Beleuchtungssettings gemäß einem der Ansprüche 1 bis 9 anpassbar sind.

11. Beleuchtungsoptik (6) gemäß Anspruch 10, **dadurch gekennzeichnet, dass** die Steuereinrichtung (23) derart ausgebildet ist, dass sie mit einem Speicher (25), in welchem Werte der Norm (N(x, y)) hinterlegt sind, in datenübertragender Weise verbunden ist.

12. Beleuchtungssystem (2) für eine Projektionsbelichtungsanlage (1) mit
12.1. einer Beleuchtungsoptik (6) gemäß einem der Ansprüche 10 bis 11 und
12.2. einer Strahlungsquelle (5) zur Erzeugung von Beleuchtungsstrahlung (7).

13. Projektionsbelichtungsanlage (1) für die Mikrolithographie umfassend
13.1. ein Beleuchtungssystem (2) gemäß Anspruch 12,
13.2. eine Projektionsoptik (13) zur Abbildung eines im Objektfeld (3) angeordneten Retikels (8) in ein Bildfeld (14).

14. Verfahren zur Herstellung eines mikro- oder nanostrukturierten Bauelements umfassend die folgenden Schritte:
14.1. Bereitstellen einer Projektionsbelichtungsanlage (1) für die Mikrolithographie,
14.2. Beleuchten eines im Objektfeld (3) angeordneten Retikels (8) zur Projektion von Strukturen (9) auf dem Retikel (8) auf eine strahlungsempfindliche Schicht eines in einem Bildfeld (14) der Projektionsbelichtungsanlage (1) angeordneten Wafers (18),
14.3. wobei das Beleuchtungssetting zur Beleuchtung des Retikels (8) gemäß einem der Ansprüche 1 bis 9 eingestellt wird,
14.4. Entwickeln der belichteten Schicht auf dem Wafer (18).

## Claims

1. Method for setting an illumination setting for illuminating an object field (3) of a projection exposure apparatus (1), comprising the following steps:
1.1. providing an illumination system (2) for illuminating an object field (3) with illumination radiation (7),
1.2. prescribing at least one parameter (P) for characterizing the quality of the illumination of the object field (3),
1.3. determining a spatially resolved function P(ΔI(x,y)) of the dependence of the at least one parameter (P) on a change in the intensity of the illumination radiation (7) (ΔI(x,y)) in the illumination pupil,
1.4. determining a norm (N(x,y)) of a directional derivative of this function P(ΔI(x,y)),
1.5. adapting an illumination setting for illuminating the object field (3) to the norm (N(x,y)).

2. Method according to Claim 1, **characterized in that** the at least one parameter (P) for characterizing the quality of the illumination of the object field (3) is selected from the following list: line width (CD, critical dimension), overlay, imaging telecentricity, CD uniformity, HV performance, line edge roughness, line width roughness, tip-to-tip distances of critical features, edge slope (NILS, normalized image log slope), contrast.

3. Method according to either of the preceding claims, **characterized in that** one or more prescribed structures (9) of masks (8) and/or aperture stops and/or a diameter of a cross section of the illumination radiation (7) are taken into account when determining the function P(ΔI(x,y)).

4. Method according to any one of the preceding claims, **characterized in that,** for the purposes of adapting the illumination pupil, a distribution and/or intensity of a plurality of pupil spots is adapted.

5. Method according to any one of the preceding claims, **characterized in that,** for the purposes of adapting the illumination pupil, a plurality of pupil spots are displaced by virtue of a plurality of individual mirrors (21) of a facet mirror (20, 22) of the illumination optical unit (6) being displaced.

6. Method according to Claim 5, **characterized in that,** for the purposes of adapting the illumination pupil, the illumination pupil is rotated and/or displaced as a whole.

7. Method according to any one of Claims 1 to 3, **characterized in that,** for the purposes of adapting the illumination pupil, an arrangement of facets on a facet mirror is adapted to the norm (N(x,y)) in such a way that at least a subset of the facet mirrors has a predetermined minimum distance (dₘᵢₙ) from areas (x,y) in which the norm (N(x,y)) is greater than a predetermined maximum value.

8. Method according to any one of the preceding claims, **characterized in that** the illumination setting is adapted during the exposure of a wafer (18).

9. Method according to any one of the preceding claims, **characterized in that,** for the purposes of adapting the illumination setting, a coordinate system is defined for a process window, in which coordinate system at least one coordinate corresponds to one or more system-internal parameters of the illumination system (2), and the illumination setting is adapted in such a way that the process window is increased in the direction of this at least one coordinate.

10. Illumination optical unit (6) for a projection exposure apparatus (1), comprising
10.1. a first facet mirror comprising a multiplicity of first facets and
10.2. a second facet mirror comprising a multiplicity of second facets,
10.3. wherein one of the first facets in each case is assigned or can be assigned to one of the second facets in each case for the purposes of forming an illumination channel,
10.4. wherein the totality of the illumination channels formed thus in each case form an illumination setting for illuminating an object field (3), and
10.5. **characterized by** a control device, configured such that the adjustable illumination settings according to any one of Claims 1 to 9 are adaptable.

11. Illumination optical unit (6) according to Claim 10, **characterized in that** the control device (23) is embodied in such a way that it has a data-transmitting connection to a memory (25), in which values of the norm (N(x,y)) are saved.

12. Illumination system (2) for a projection exposure apparatus (1), comprising
12.1. an illumination optical unit (6) according to either of Claims 10 and 11, and
12.2. a radiation source (5) for producing illumination radiation (7).

13. Microlithographic projection exposure apparatus (1), comprising
13.1. an illumination system (2) according to Claim 12,
13.2. a projection optical unit (13) for imaging a reticle (8) that is arranged in the object field (3) into an image field (14).

14. Method for producing a microstructured or nanostructured component, comprising the following steps:
14.1. providing a microlithographic projection exposure apparatus (1),
14.2. illuminating a reticle (8) that is arranged in the object field (3) for projecting structures (9) on the reticle (8) onto a radiation-sensitive layer of a wafer (18) that is arranged in an image field (14) of the projection exposure apparatus (1),
14.3. wherein the illumination setting for illuminating the reticle (8) is set according to any one of Claims 1 to 9,
14.4. developing the exposed layer on the wafer (18).

## Revendications

1. Procédé pour régler un montage d'éclairage destiné à l'éclairage d'un champ d'objet (3) d'un équipement d'éclairage par projection (1), comprenant les étapes suivantes :
1.1 fourniture d'un système d'éclairage (2) destiné à éclairer un champ d'objet (3) avec un rayonnement d'éclairage (7),
1.2 prédéfinition d'au moins un paramètre (P) destiné à la caractérisation de la qualité de l'éclairage du champ d'objet (3),
1.3 détermination d'une fonction à résolution spatiale P(ΔI(x,y)) de la dépendance de l'au moins un paramètre (P) à une modification de l'intensité du rayonnement d'éclairage (7) (ΔI(x,y)) dans la pupille d'éclairage,
1.4 détermination d'une norme (N(x,y)) d'une dérivée directionnelle de cette fonction P(ΔI(x,y)),
1.5 adaptation d'un montage d'éclairage pour l'éclairage du champ d'objet (3) à la norme (N(x,y)).

2. Procédé selon la revendication 1, **caractérisé en ce que** l'au moins un paramètre (P) destiné à la caractérisation de la qualité de l'éclairage du champ d'objet (3) est sélectionné dans la liste suivante : largeur de ligne (CD, dimension critique), recouvrement, télécentrie d'imagerie, uniformité de CD, performances HV, irrégularité de bord de ligne, irrégularité de largeur de ligne, écarts de pointe à pointe des caractéristiques critiques, pente d'arête (NILS, pente logarithmique normalisée de l'image), contraste.

3. Procédé selon l'une des revendications précédentes, **caractérisé en ce que** lors de la détermination de la fonction P(ΔI(x,y)), une ou plusieurs structures (9) prédéfinies de masques (8) et/ou de diagrammes d'ouverture et/ou un diamètre d'une section transversale du rayonnement d'éclairage (7) sont pris en compte.

4. Procédé selon l'une des revendications précédentes, **caractérisé en ce que** pour l'adaptation de la pupille d'éclairage, une distribution et/ou une intensité d'une pluralité de points de pupille est adaptée.

5. Procédé selon l'une des revendications précédentes, **caractérisé en ce que** pour l'adaptation de la pupille d'éclairage, une pluralité de points de pupille sont déplacés en déplaçant une pluralité de miroirs individuels (21) d'un miroir à facettes (20, 22) de l'optique d'éclairage (6).

6. Procédé selon la revendication 5, **caractérisé en ce que** pour l'adaptation de la pupille d'éclairage, la pupille d'éclairage est tournée et/ou décalée en tant qu'ensemble.

7. Procédé selon l'une des revendications 1 à 3, **caractérisé en ce que** pour l'adaptation de la pupille d'éclairage, un arrangement de facettes sur un miroir à facettes est adapté à la norme (N(x,y)) de telle sorte qu'au moins un sous-ensemble du miroir à facettes présente un écart minimal (dₘᵢₙ) prédéfini par rapport aux zones (x, y) dans lesquelles la norme (N(x,y)) est supérieure à une valeur maximale prédéfinie.

8. Procédé selon l'une des revendications précédentes, **caractérisé en ce que** le montage d'éclairage est adapté pendant l'exposition d'une galette (18).

9. Procédé selon l'une des revendications précédentes, **caractérisé en ce que** pour l'adaptation du montage d'éclairage, un système de coordonnées est défini pour une fenêtre de processus, avec lequel au moins une coordonnée correspond à un ou plusieurs paramètres internes au système du système d'éclairage (2), et le montage d'éclairage est adapté de telle sorte que la fenêtre de processus est agrandie en direction de cette au moins une coordonnée.

10. Optique d'éclairage (6) pour un équipement d'éclairage par projection (1), comprenant
10.1 un premier miroir à facettes comprenant une pluralité de premières facettes et
10.2 un deuxième miroir à facettes comprenant une pluralité de deuxièmes facettes,
10.3 à chaque fois l'une des premières facettes étant associée ou pouvant être associée à chaque fois à l'une des deuxièmes facettes en vue de former un canal d'éclairage,
10.4 l'ensemble des canaux d'éclairage ainsi formés formant respectivement un montage d'éclairage destiné à l'éclairage d'un champ d'objet (3), et
10.5 **caractérisé par** un dispositif de commande, configuré de telle sorte que les montages d'éclairage réglables sont adaptables selon l'une des revendications 1 à 9.

11. Optique d'éclairage (6) selon la revendication 10, **caractérisé en ce que** le dispositif de commande (23) est configuré de telle sorte qu'il est relié de manière à transmettre des données avec une mémoire (25) dans laquelle sont stockées des valeurs de la norme (N(x,y)).

12. Système d'éclairage (2) pour un équipement d'éclairage par projection (1), comprenant
12.1 une optique d'éclairage (6) selon l'une des revendications 10 à 11 et
12.2 une source de rayonnement (5) destinée à générer un rayonnement d'éclairage (7).

13. Équipement d'éclairage par projection (1) pour la microlithographie, comprenant
13.1 un système d'éclairage (2) selon la revendication 12,
13.2 une optique de projection (13) destinée à former dans un champ d'image (14) un réticule (8) disposé dans le champ d'objet (3).

14. Procédé de fabrication d'un composant micro- ou nanostructuré, comprenant les étapes suivantes :
14.1 fourniture d'un équipement d'éclairage par projection (1) pour la microlithographie,
14.2 éclairage d'un réticule (8) disposé dans le champ d'objet (3) en vue de la projection de structures (9) sur le réticule (8) sur une couche sensible au rayonnement d'une galette (18) disposée dans le champ d'image (14) de l'équipement d'éclairage par projection (1),
14.3 le montage d'éclairage destiné à l'éclairage du réticule (8) étant réglé selon l'une des revendications 1 à 9,
14.4 développement de la couche exposée sur la galette (18) .
